Europäisches Patentamt

(19) European Patent Office

Office européen des brevets

(11) EP 0 779 715 A2

(12) EUROPEAN PATENT APPLICATION

(43) Date of publication:
18.06.1997 Bulletin 1997/25

(51) Int. Cl.$^6$: **H03M 11/24**, H01H 13/70

(21) Application number: 96119396.8

(22) Date of filing: 04.12.1996

(84) Designated Contracting States:
DE FR GB IT

(30) Priority: 14.12.1995 FI 956005

(71) Applicant: NOKIA TECHNOLOGY GmbH
75175 Pforzheim (DE)

(72) Inventors:
• Siitari, Kimmo
24260 Salo (FI)
• Haapakoski, Hannu
24280 Salo (FI)

(54) **Keyboard structure for reducing electromagnetic interference**

(57) The invention relates to a keyboard structure (13) which is particularly suited to film keyboards and where EMC protection can be realized by structural means, with fewer auxiliary components than in the prior art. A metal bubble (7), which is the switching member of the keys, is permanently coupled to ground, so that it establishes an ESD protection. The row and column conductors (3a - 4d) are coupled to voltage dividers (11, 12), so that a given row and a given column correspond to a given pair of analog voltage values ($V_{14}$, $V_{16}$). Each pair of values unambiguously corresponds to a certain key. The analog voltage values are converted to digital form in the A/D converters (19, 20) provided in the microprocessor (8) or in a connected auxiliary circuit, such as a bus buffer.

Fig. 2

## Description

The present invention relates generally to reducing electromagnetic interference in keyboard devices, and particularly to a film keyboard structure which reduces electromagnetic interference. Electromagnetic interference here refers particularly to ESD, Electro Static Discharge, and to RFI, Radio Frequency Interference.

When objects and people move in relation to each other, there are created electrostatic charges, where the potential differences may be several thousands of volts, but the amount of energy bound in these charges is usually insignificant. The charges are discharged suddenly, when two charged objects fall so near to each other that the breakdown insulation in the materials in between is not sufficient, or when the electricity otherwise finds a path with a sufficiently low resistance. The charge may be discharged in one or several pulses. These discharges are not dangerous for people, but electronic appliances contain a lot of semiconductor components that are sensitive to static electricity. If an electrostatic charge is discharged through a semiconductor component, its inner structure may be damaged, even if the potential difference were only a few hundreds of volts.

According to the Maxwell equations, moving electric charges cause electromagnetic radiation. Particularly high-frequency electric signals, which are meant to proceed in conductors, create an electromagnetic radiation field in the surroundings. The radiation and the movement of the electric charges are interactive, so that the said electromagnetic radiation field may in part cause undesired phenomena in other electronic devices. International and national standards and regulations set given limit values, which represent the maximum of the radiation emitted from electric appliances at different frequencies. Measurements are generally carried out in a frequency range of 30 - 1,000 MHz and with varying polarization.

Electro Magnetic Compatibility, EMC, is a general concept which, when applied to electronic devices, includes for instance the tolerance of electrostatic discharges and the fact that the device does not emit radiation above a given level nor is itself disturbed by external electromagnetic radiation. Devices must be planned and built so that they fulfill the respective EMC requirements.

At present many devices utilize film keyboards for feeding data into a microprocessor or other similar semiconductor circuit. A film keyboard comprises several planar layers arranged on top of each other; the said layers may contain separate parts for individual keys, but the film keyboard forms an essentially uniform external surface as a difference from keyboards constructed of several different press keys, where the keys are independently moving tiny mechanisms. Film keyboards can be extremely easily integrated to form a part of the casing of an electronic device, and they are useful particularly in applications where the device plus keyboard must be inside a compact casing in order to achieve water or dust resistance, for instance.

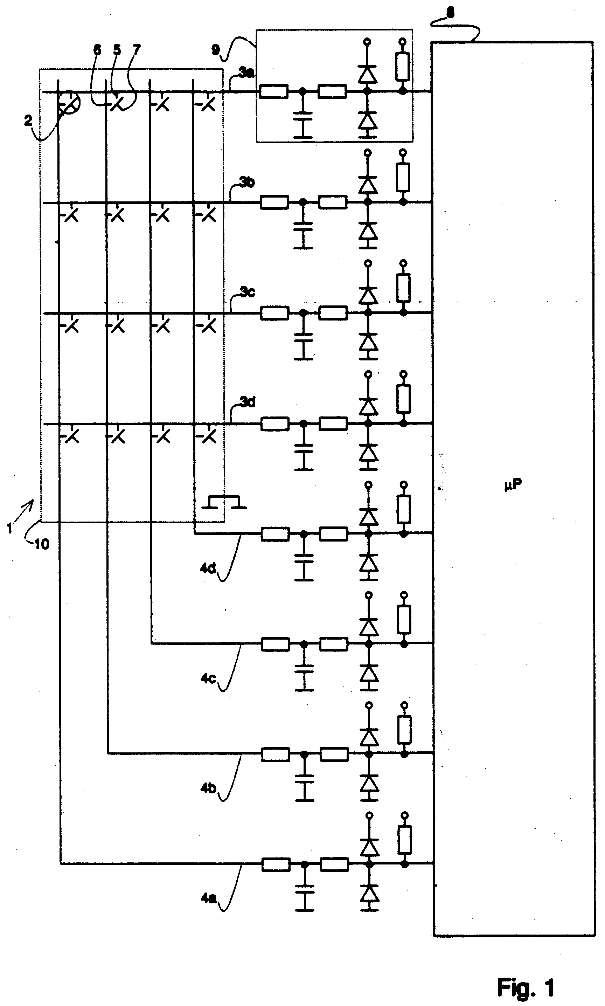

In a typical film keyboard the keys are divided into rows and columns, which are named so that in the normal operation position, the rows are essentially horizontal and the columns essentially vertical. As such, the keys in a film keyboard do not have to be in any regular order, but it is simplest to describe the features of the prior art by observing a regular square keyboard illustrated in figure 1. It comprises 16 keys 2, as well as row wires 3a, 3b, 3c, 3d and column wires 4a, 4b, 4c, 4d, which are insulated from each other. The keys 2 are located essentially at the junctions of the row and column conductors, so that each key contains contact surfaces 5 and 6 in connection to the intersecting row and column conductor, as well as a metal spring or bubble 7. When a key is pressed, the metal spring or bubble 7 is pushed against the contact surfaces 5 and 6 and thus forms a low-resistance connection therebetween.

The topmost layer of the keyboard is an insulation layer, which for the sake of clarity is not illustrated in figure 1. Underneath it, there are the metal springs or bubbles 7 and the row and column wires with their contact surfaces. In between different conductor parts, there are provided insulation layers. The thickness and mutual arrangement of the conductor and insulation layers may vary depending on the desired properties of the keyboard in question.

A microprocessor 8 or a similar apparatus reads the keyboard 1 for instance so that it normally keeps all rows 3a, 3b, 3c, 3d on a level corresponding to the TTL signal "1", but regularly writes for each row a momentary level "0". The columns 4a, 4b, 4c, 4d are normally switched with so-called pull-up resistors to level "1", but if a given key is pressed at the same time as the corresponding row has the value "0", the key switches the said column to level "0", which is detected in the processor 8. The processor interprets a simultaneous level "0" of a given row and column as a depression of the key located at their junction. The use of TTL signal levels means that in order to make this kind of keyboard to work, the elements taking part in the key switching operation must not at any stage be coupled to ground potential.

According to figure 1, a traditional film keyboard is generally coupled directly to a microprocessor 8 or to one of its auxiliary circuits (such as a bus buffer, not illustrated in the drawing), which is essentially a semiconductor circuit and thus normally sensitive to electrostatic discharges. If the device does not have ESD protection, the static charge of the user touching the keyboard may be discharged through the topmost insulation layer of the keyboard to the metal spring or bubble 7 and thereby to the microprocessor 8 along the row and/or column conductors 3a - 3d, 4a - 4d. As was in general terms explained above, the discharge may damage the inner structure of the microprocessor. Moreover, a rapid reading cycle, i.e. changing the TTL levels in the row conductors 3a - 3d, as well as other rapid mode changes of the microprocessor 8, which changes are coupled to the keyboard conductors, may cause electromagnetic radiation through the keyboard.

In the prior art there are known two types of solutions for the above described problems. The first alternative, according to figure 1, is to use protector components 9, which comprise serial resistors and clamp diodes. In order to make the protection as comprehensive as possible, each signal line connected to the processor 8 must be provided with its own protector components. In the application of figure 1, the protection of one row requires six components, and even a small 4 x 4 keyboard contains eight rows, which means that the total number of protector components rises up to 48. These take up space around the processor, cause losses and increase production expenses.

Another known solution is to provide in the film structure of the film keyboard 1 an ground plane 10 covering the whole keyboard, which ground plane is called ESD ground or RFI ground and is the first conducting layer when starting from the keyboard surface. The purpose is that the electrostatic discharge emitted from the user is conducted to the ground potential through the ground plane 10, and is thus not conducted to other structures of the keyboard, wherefore the ground plane 10 must be completely insulated from the metal springs or bubbles 7 and conductors 3a - 4d. If the spreading of radio frequency interference RFI to the surroundings should also be prevented, the ground plane 10 must be essentially uniform. The production of a separate plane to the layer structure of the film keyboard and the use of metal (generally silver) in the formation of a uniform ground plane both increase production costs.

The object of the present invention is to introduce a keyboard structure which enables the realization of EMC protection in an advantageous fashion and is applicable to film keyboards. Another object of the invention is to introduce a keyboard structure which requires only a limited amount of separate protector components against electromagnetic interference. Yet another object of the invention is that the invented structure is well suited to the serial production of keyboards and that the ensuing production costs are reasonable.

The objects of the invention are achieved by coupling the switching member, which causes the switching operation corresponding to a depression of a key, to ground potential ad by arranging the reading of the keyboard so that its conductors can be coupled to ground potential in connection with a keystroke.

The keyboard structure according to the invention, comprising a switching member for each press key, is characterized in that the said switching member is permanently coupled to ground potential.

The invention is based on the realization that the switching member itself, the one that causes the switching operation corresponding to a keystroke, can be permanently coupled to ground potential, in which case an electrostatic discharge directed thereto is immediately coupled to ground and does not create interference pulses extending as far as the semiconductor components. Now the reading of the keyboard must naturally be realized so that its conductors can, in connection with a keystroke, be coupled to ground potential. In a preferred embodiment of the structure of the invention, there are formed resistance networks for the row and column parts of the keyboard, so that a given row and a given column always correspond to a given point in the connected resistor network.

By conducting constant voltage to one end of the resistor network, there are created two voltage division couplings, which both produce a determined direct-current analog voltage per each row and respectively per each column. The said voltages are converted into digital signals and are as such in a form which is understood by the microprocessor. The conversion can take place in the microprocessor itself or in a separate converter circuit.

In a preferred embodiment of the invention, there can also be realized a RFI protection by using protector components in connection with the signal lines connected to the processor. Because a preferred embodiment of the invention advantageously contains only two signal lines and the keyboard operates on direct-current voltage, the number of required components is low and the components can be dimensioned so that they cause as little losses as possible.

In another preferred embodiment of the invention, the conductors corresponding to the rows and columns of the keyboard are maintained at a given potential other than zero when no key is being pressed. In connection with the depression of a given key, its grounded switching member connects one row conductor and one column conductor to ground. A change in the potential of the conductors is interpreted as a keystroke.

The invention is explained in more detail below, with reference to the preferred embodiments described as examples and to the appended drawings, where

figure 1    illustrates a prior art film keyboard and its connection to a microprocessor,

figure 2    illustrates a preferred embodiment of the keyboard structure of the invention and its connection to a microprocessor,

figure 3    shows a detail of figure 2, and

figure 4    illustrates another preferred embodiment of the invention.

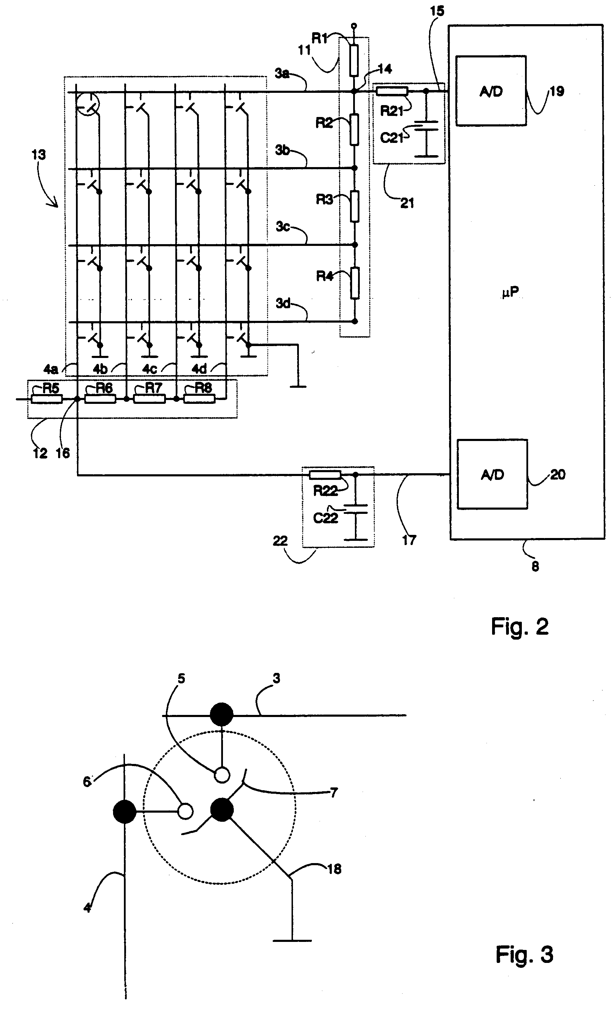

Figure 1 was already referred to above, in the description of the state of the art, and therefore the following description of the invention and its preferred embodiments contains mainly references to figures 2 - 4. Like numbers for like parts are used in the drawings.

Figure 2 illustrates a preferred embodiment of the keyboard structure according to the present invention, as well as its coupling to a microprocessor 8. Here the microprocessor 8 is an exemplary device and represents any circuit arrangement containing semiconductor components, which circuit is controlled by means of a keyboard, and where it is necessary to pay attention to the electromagnetic protection of the arrangement. The keyboard structure of figure 2 comprises two resistor networks, i.e. arrays 11 and 12 of resistors coupled in series, both arrays being at one end coupled to the supply voltage marked Vcc. The first resistor network 11 corresponds to the rows of the keyboard 13 and comprises the serially coupled resistors R1, R2, R3 and R4, of which the first end of the resistor R1 is coupled to the supply voltage. The second resistor network 12 corresponds to the columns of the keyboard 13 and comprises the serially coupled resistors R5, R6, R7 and R8, of which the first end of the resistor R5 is coupled to the supply voltage Vcc.

The coupling junction 14 between the resistors R1 and R2 is coupled both to the keyboard conductor 3a leading to the keys of the first row and to the row input 15 of the microprocessor. The coupling junction between the resistors R2 and R3 is coupled to the keyboard conductor 3b leading to the keys of the second row, the coupling junction between the resistors R3 and R4 is coupled to the keyboard conductor 3c leading to the keys of the third row and the end of the resistor R4 is coupled to the keyboard conductor 3d leading to the keys of the fourth row. Respectively, the coupling junction 16 between the resistors R5 and R6 is coupled both to the keyboard conductor 4a leading to the keys of the first column and to the column input 17 of the microprocessor. The coupling junction between the resistors R6 and R7 is coupled to the keyboard conductor 4b leading to the keys of the second column, the coupling junction between the resistors R7 and R8 is coupled to the keyboard conductor 4c leading to the keys of the third column and the end of the resistor R8 is coupled to the keyboard conductor 4d leading to the keys of the fourth column. In the embodiment of figure 2, the coupling junctions 14 and 16 are coupled to the row input 15 and column input 17 of the microprocessor 8 via filter couplings 21 and 22. The purpose of these will be discussed later on.

According to figure 3, each key comprises contact surfaces 5 and 6 connected to the row and column conductors 3, 4 which intersect at the key in question, as well as a switching member 7 which can as such be a similar metal spring or bubble as in the keyboard structures of the prior art, except that it is coupled to ground potential for instance by means of a strip-like conductor or foil conductor 18, which in the case of a film keyboard lies in a given layer of the film structure and connects all switching members.

Now we shall explain the operation of the keyboard structure of figure 2. When no key is being pressed, the keyboard conductors 3a - 4d are open. Supposedly there is not a lot of current passing in the signal conductors leading to the row input 15 and column input 17 of the microprocessor, so that the potential of the coupling junctions 14 and 16 is essentially equal to the supply voltage Vcc. The A/D converters 19 and 20 contained in the microprocessor convert this potential into a given digital value, which is interpreted in the processor so that no key is being pressed. When the user depresses a key, for instance the one lowest on the right, the switching member 7 provided in the key forms a low-resistance connection in between the contact surfaces 5 and 6 of the key, which then couples the end of the last resistor of each resistor network 11 and 12 (in the row resistor network 11 resistor R4 and in the column resistor network 12 resistor R8) to ground potential. According to a known voltage division formula, the potential $V_{14}$ of the coupling junction 14 is now

$$V_{14} = \frac{R_2 + R_3 + R_4}{R_{1234}} V_{cc} \qquad (1)$$

and the potential $V_{16}$ of the coupling junction 16 is

$$V_{16} = \frac{R_6 + R_7 + R_8}{R_{5678}} V_{cc} \qquad (2)$$

where $R_{1234}$ and $R_{5678}$ mean the added serial resistances of the resistor networks 11 and 12. The depression of any of the keys in the lowest row causes in the coupling junction 14 the same potential as in the formula (1), and the depression of any of the keys in the left-hand side column causes in the coupling junction 16 the same potential as in the formula (2). The potential conforms to each row and column on a more general level, too. For example, the depression of any of the keys in the second highest row generates in the coupling junction 14 the potential

$$V_{14}' = \frac{R_2}{R_1 + R_2} V_{cc} \qquad (3)$$

and because a given row and a given column intersect only at one key, a certain combination of potentials at the coupling junctions 14 and 16 refers unambiguously to one particular key.

Because it is supposed that not much current flows to the row input 15 and to the column input 17, the potential detected there is always essentially equal to the potential of the connected coupling junctions 14 and 16. By intermediation of the A/D converters 19 and 20, the microprocessor 8 obtains as signal inputs a digital value pair which unambiguously corresponds to the depression of a given key. This value pair can be further processed in the microprocessor in ways known in the prior art. The resolution of the A/D converters 19 and 20 determines how many different voltage values can be identified at the coupling junctions 14 and 16, i.e. how many rows and columns the keyboard can have. In the embodiment of figure 2, a depression of any of the keys in the highest row connects the coupling junction 14 essentially to ground potential, and the depression of any of the keys in the lowest row connects the coupling junction 14 to the potential according to the formula (1). The values of the resistors in the resistor network 11 must be chosen so that the potential values corresponding to other rows fall in between these extreme values with intervals that are at least the size of the resolution capacity of the A/D converter 19.

In the embodiment of figure 2, the filter couplings 21 and 22 realize the RFI protection. Because the keyboard 13 works only with slowly changing direct-current voltages, it does not create radio frequency interference itself. Rapid inner mode changes of the microprocessor 8 may cause high-frequency signal components which tend to be coupled to the conductors leading out of the processor. The proceeding of interferences as far as the keyboard is prevented by forming in front of both the row and column inputs a filter circuit 21, 22 according to a prior art low pass structure, which filter circuit comprises a fairly large serial resistor R21, R22 and a fairly small capacitance C21, C22, which is coupled in between one end of the said serial resistor and ground potential. The serial resistors R21 and R22 can be large, because the potential values of the coupling junctions 14 and 16 corresponding to the keystrokes do not require much current in order to be transmitted; remarkable power losses are therefore not caused in the serial resistors. Other types of filter couplings, known as such for those skilled in the art, can be used for attenuating high-frequency interference in the conductors in between the microprocessor 8 and the keyboard 13.

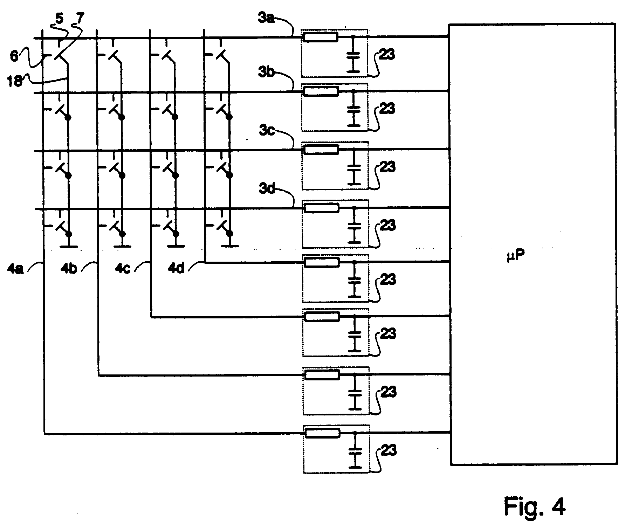

Figure 4 shows another preferred embodiment of the invention, where voltage division couplings are not applied for each row and column individually, but every row conductor 3a - 3d and every column conductor 4a - 4d forms its own supply line to the microprocessor 8, in the same fashion as in the prior art arrangement illustrated in figure 1. In this embodiment the principal idea is that the processor 8 maintains all row and column conductors 3a - 4d all the time in a given potential other than zero, for example by means of so-called pull-up resistors (not illustrated in the drawing). Each press key comprises a switching member 7, which again is a similar metal spring or bubble as in the embodiments illustrated in figures 1 - 3. The switching members 7 of all keys are coupled to ground by the foil conductor 18. When a given key is depressed, its switching member 7 touches the contact surfaces 5 and 6 of the row and column conductors intersecting at the said key, and thus couples the said conductors to ground. The processor 8 detects a drop in the potential of a given column conductor and a given row conductor and interprets this as a depression of the key located at the junction of the said conductors. In this embodiment, there are not needed separate A/D converters for interpreting the keyboard signals, but in each signal line connected to the processor there is advantageously provided a separate filter coupling 23 for attenuating radio frequency interference.

In the above specification, the preferred embodiments of the invention are described with reference to two-dimensional keyboards, where the keys are grouped in rows and columns, and where each row and column is provided with a corresponding conductor running along the whole length of the respective row or column. However, the invention is easily applied to keyboards where the grouping of the keys differs from the one described above, or where several auxiliary conductors are used for each row and/or column. The keyboard according to the invention may also contain only one key, one row or one column.

The present invention brings forth remarkable advantages as compared to the prior art, because the number of auxiliary components required for the EMC protection in the immediate vicinity of the semiconductor component coupled to the keyboard is considerably reduced. This saves both board space and production expenses. When the keyboard is operated with direct-current voltages, which shift their mode slowly, it can itself serve as the ESD protection. A uniform RFI protection layer is not needed, but the protection against radio frequency interference can be arranged by means of a few filter couplings. Admittedly a preferred embodiment of the invention presupposes that the keyboard signals are A/D-converted in the processor or in the immediate vicinity thereof, but because many commercially available microprocessors already include suitable A/D converters, this is not an immoderate requirement.

## Claims

1. A keyboard structure (13) comprising for each key an electroconductive first contact surface (5), a electroconductive second contact surface (6) and an electroconductive switching member (7), where the activation of a key is carried out by moving the said switching member (7) with respect to the said contact surfaces (5, 6) so that the said switching member (7) is set into contact with the said first (5) and second (6) contact surfaces in order to establish a low-resistance connection therebetween, **characterized** in that the said switching member (7) is permanently coupled to ground potential.

2. A keyboard structure (13) according to claim 1, **characterized** in that the keys are grouped into rows and columns, and that the said keyboard structure comprises row conductors (3a - 3d) corresponding to the said rows and column conductors (4a - 4d) corresponding to the said columns, so that for each key, the said first contact surface (5) is connected to the row conductor (3) of the particular row where the said key is located, ad the said second contact surface (6) is connected to the column conductor (4) of the particular column where the said key is located.

3. A keyboard structure (13) according to claim 2, **characterized** in that it comprises a first voltage divider (11) corresponding to the said rows ad a second voltage divider (12) corresponding to the said columns, and that the said first (11) and second (12) voltage divider are permanently coupled to a given potential (Vcc) other than ground potential, of which the first voltage divider (11) is arranged to generate, in connection to a keystroke, a determined first voltage value ($V_{14}$) corresponding to the row where the depressed key is located, and the said second voltage divider (12) is arranged to generate, in connection to a keystroke, a determined second voltage value ($V_{16}$) corresponding to the column where the depressed key is located.

4. A keyboard structure (13) according to claim 3, **characterized** in that the said first (11) and second (12) voltage divider both comprise a certain number of serially coupled resistors (R1 - R4, R5 - R8), so that the row conductor (3a - 3d) corresponding to each row is coupled to the said first voltage divider (11) at a different location, and that the column conductor (4a - 4d) corresponding to each column is coupled to the said second voltage divider (12) at a different location, and that the said coupling locations are located in between the serially coupled resistors (R1 - R4, R5 - R8).

5. A keyboard structure according to claim 3 or 4, **characterized** in that the said first voltage divider (11) comprises a first coupling junction (14) and the second voltage divider (12) comprises a second coupling junction (16), and that the said first (14) and second (16) coupling junctions are coupled to an electronic device (8) in order to transmit the keyboard data thereto.

6. A keyboard structure (13) according to claim 5, **characterized** in that the signal path from the said first coupling junction (14) to the said electronic device (8) and the signal path from the said second coupling junction (16) to the said electronic device (8) respectively comprise a first (21) and second (22) filter circuit for attenuating high-frequency interference.

7. A keyboard structure (13) according to claim 6, **characterized** in that the said first (21) and second (22) filter circuits are low pass structures comprising a serial resistor (R21, R22) and a parallel capacitance (C21, C22).

8. A keyboard structure (13) according to any of the preceding claims, **characterized** in that it comprises at least one A/D converter (19, 20) for converting the data produced by the said keyboard structure (13) from analog to digital form.

9. A keyboard structure (13) according to claim 8, **characterized** in that at least one of the said A/D converters (19, 20) is integrated as part of the electronic device (8), the operation whereof is controlled by the said keyboard.

10. A keyboard structure (13) according to claim 2, **characterized** in that each of the said row conductors (3a - 3d) and column conductors (4a - 4d) comprises a coupled separate signal path into the electronic device (8), the operation whereof is controlled by means of the said keyboard.

11. A keyboard structure (13) according to claim 10, **characterized** in that each of the said row conductors (3a - 3d) and column conductors (4a - 4d) comprises a connected filter circuit (23) in between the said keyboard (13) and the said electronic device (8) in order to attenuate high-frequency interference.

Fig. 1

Fig. 2

Fig. 3

Fig. 4